# EUROPEAN PATENT APPLICATION

(11) **EP 0 899 836 A1**
(43) Date of publication of application: **03.03.1999**
(21) Application number: 98306601.0
(22) Date of filing: 18.08.1998
(51) Int. Cl.: H01S 3/025, H01S 3/085

(54) **Semiconductor laser device**

(30) Priority: 27.08.1997 US 921942
(71) Applicant: XEROX CORPORATION, Rochester, New York 14644 (US)
(72) Inventor: Thornton, Robert L., Los Altos, CA 94022 (US); Street, Robert A., Palo Alto, CA 94306 (US)
(74) Representative: Rackham, Stephen Neil

(57) **Abstract**

A vertical cavity surface emitting laser (VCSEL) (52) is provided with an integrated detector (72). The detector (72) may be of hydrogenated amorphous silicon (a-Si:H) or alloys thereof with transparent electrodes (76, 84), of for example of indium tin oxide (ITO). Advantages provided by this structure include increased size of the detector electrodes (76, 84), low attenuation of the laser beam, capability of adjusting the detector layer thickness to maximize beam output power, simplicity of detector formation processes, and low temperature detector formation processes to minimize VCSEL damage during detector formation.

## Description

The present invention relates to semiconductor lasers. More specifically, the present invention relates to semiconductor lasers combined with photodetectors.

Semiconductor lasers are important devices used in a variety of applications including printing, scanning, communications, etc. Semiconductor lasers generally fall into two categories: edge-emitting and vertical cavity surface emitting (VCSEL). Each of these types of devices are well known. In an edge emitting semiconductor laser structure, a number of layers are deposited onto a substrate. Following deposition, the edges of the structure are cleaved to form partially transmissive mirrors. One or more of the deposited layers forms an optical cavity, bound at its edges by the mirrors. Lasing occurs within the cavity between the mirrors, and the laser beam exits at one or both of the edges of the laser structure in a direction parallel to the plane of the layers.

Surface emitting lasers are similar in concept, but differ in that the laser beam is emitted normal to the top surface of the laser device. The mirrors are above and below the device, as opposed to at each edge of the device. For certain applications, a surface emitting laser provides advantages over an edge emitting laser. For example, 2-dimensional arrays of vertical cavity lasers may be produced in wafer form, whereas edge emitting lasers typically must be mechanically jointed to form such arrays. Also, surface emitting lasers typically emit circularly symmetric Gaussian beams, as compared to the highly eccentric elliptical beams of edge emitting lasers. Accordingly, today there is much interest and development centered around surface emitting lasers.

In many laser systems it is necessary to measure the power of the beam emitted by the laser. For example, it is necessary in many applications to provide a constant, predetermined beam profile, which requires compensation for the laser's temperature, aging, etc. Beam power detection generally involves interposing a detector in the laser beam path. Where an edge emitting laser is of the type having two beam emissions, one from each edge (facet), one beam is referred to as a forward emission beam and the other as a rear emission beam. The forward emission beam will generally be of a higher power than the rear emission beam. Hence, the forward emission beam is generally the operable beam performing the desired function, such as writing to a photoreceptor, pulsing encoded signals to a transmission line, cutting material, etc., while the rear emission is generally not used. However, the ratio of the power of the forward emission beam to the power of the rear emission beam can be measured. By placing a detector in the path of the rear emission beam, and by employing the aforementioned power ratio, the power of the forward emission beam may be determined.

However, this approach has limited utility for surface emitting laser structures, for several reasons. Typically, surface emitting laser structures include a gallium arsenide (GaAs) substrate, which is opaque for wavelengths shorter than 870 nm. The emission wavelength of interest is often shorter than 870 nm. Thus, for many applications, the substrate will be opaque, and the laser structure will be capable of producing only a single, surface emitted laser beam. Second, in general it is desirable to provide as high a beam power as possible, so it is a design goal to produce single beam laser structures.

An existing approach to incorporating a detector into a surface emitting laser (assumed to be single beam herein, unless otherwise stated) is to form the detector over the laser structure. See, e.g., Hasnain et al., "Monolithic Integration of Photodetector With Vertical Cavity Surface Emitting Laser", Electronics Letters, vol. 27, no. 18 (29 August 1991), p. 1630. That is, additional layers would be epitaxially grown above the laser with the same structure (e.g., single crystal) and possibly of the same material as the laser structure, which would be appropriately patterned and/or doped, and interconnected to form a detector. The detector is generally coaxial with the laser beam, and relies on partial absorption of the beam to create electron-hole pairs which are detected by methods otherwise known in the art.

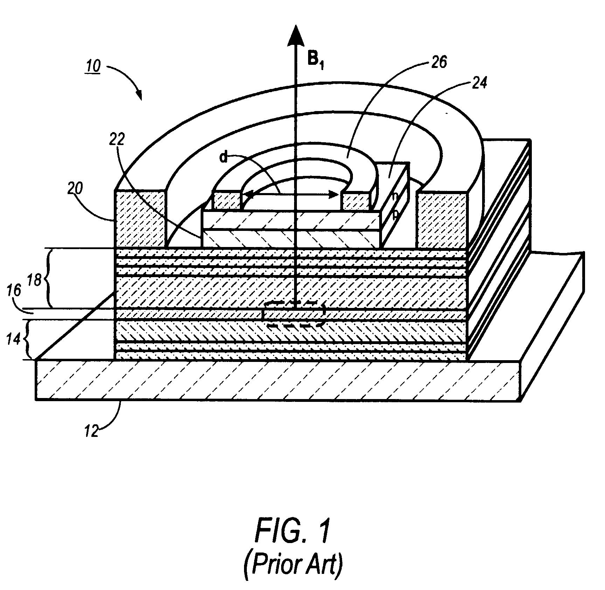

This approach has disadvantages which are a function of the geometry of the detector, and the need to provide electrical contact with the detector. These problems can best be described by reference to Fig. 1, which is a cut-away cross-section of a prior art integrated laser structure and detector 10. The integrated laser and detector are formed on a substrate 12, typically GaAs. A number of thin layers are first deposited to form a lower mirror region 14, one or more layers are then deposited to form an active region 16, then a number of thin layers are deposited to form an upper mirror region 18. Typically, a metal, n-material electrode (not shown) is formed on the substrate, and a metal, p-material electrode 20 is formed above the upper mirror region 18. Electrode 20 is typically annular in planform, so as to maximize surface contact yet minimize interference with the laser beam B₁.

The detector portion of the integrated laser structure and detector is formed of a layer of p-type material 22, a layer of n-type material 24 formed on layer 22, and a metal n-type material electrode 26. Typically, p- and n-type layers 22, 24 are formed of doped GaAs, formed epitaxially immediately following the process of forming the laser structure. As with electrode 20, electrode 26 is typically annular in planform, and concentric with electrode 20, so as to maximize surface contact yet minimize interference with the laser beam B₁. The p-material electrode for the detector is electrode 20.

There are several limitations with this type of device. First, forming the detector structure requires additional lithographic steps, which increases the complexity and cost of manufacturing the laser structure.

Second, electrode 26 will have an inside diameter d, which is at its smallest equal to the diameter of the laser beam B₁. In operation, the detector employs photon energy from the laser beam B₁ to generate electron-hole pairs, which migrate to respective electrodes. Beam power is thus measured by measuring the extent of electron-hole pair generation (i.e., current generated in the detector). The speed of the detector is measured by the speed at which the electrons or holes travel to their respective electrodes. Those electrons or holes generated at the center of the annular electrode 26 must travel a distance equal to at least d/2. This is a relatively large distance, and results in relatively slow detection.

Third, the p- and n-type layers are formed of GaAs, a material strongly absorbing to the laser beam when the combined thickness of the layers is 1000 Å or greater (again, assuming a laser wavelength shorter than 870 nm). Typically, a design point for absorption of the beam by the detector is around 5% of the beam's energy. However, if the layers are too thin, they will be too transparent, and will not absorb sufficient photon energy to effectively serve as a detector. Thus, to obtain the desired performance from the detector, it is necessary to very precisely control the thicknesses of layers 22 and 24, which adds to the cost and complexity of manufacture.

In addition, it should be possible to tailor the thickness of the detector layers to allow constructive interference of the reflected portions of the laser beam. This provides for improved efficiency and performance of the laser. However, to accomplish this, some flexibility to adjust layer thicknesses is required, which the constraints of the GaAs detector layers cannot provide.

In this regard, it becomes necessary to effect modifications to the laser itself to account for the additional layers at the laser' surface. For example, the only way to compensate for destructive reflections from the p- and n-layer surfaces of the detector is to adjust the thicknesses of the various laser structure layers, such as the thickness of the lower mirror layer 14, part of which serves as the lower mirror below the optical cavity. This constrains optimizing the laser structure design for peak laser performance.

According to a first aspect of this invention an integrated semiconductor laser and detector structure comprises
a vertical cavity, surface emitting laser, which emits light at a wavelength, and which is formed predominantly of a first material; and
a detector which is relatively transparent to light at the wavelength emitted by said laser, and which is formed predominantly of a second material different from said first material;
said laser and said detector being aligned such that at least a portion of the light emitted by the laser is directed through the detector.

According to a second aspect of this invention a method of forming an integrated semiconductor laser and detector structure comprises the steps of:
forming a vertical cavity, surface emitting laser with uppermost insulating layer, which emits light at a wavelength, and which is formed primarily of a first material; and
providing over said vertical cavity, surface emitting laser a detector comprising a photodetector and electrodes, said photodetector and said electrodes being relatively transparent to light at the wavelength emitted by said laser, and said detector formed primarily of a second material different from said first material;
said laser and said detector being aligned such that at least a portion of the light emitted by the laser is directed through the photodetector and electrodes.

The present invention is a process and structure which address the shortcomings of the prior techniques of integrating a laser structure and a detector structure. According to one embodiment of the present invention, a surface emitting laser is provided at its output surface with a p-i-n photodiode sandwiched between transparent electrode layers, for example formed of indium tin oxide (ITO). The p-material electrode may be common with the p-material electrode of the surface emitting laser, or may be a separate electrode. The detector structure, consisting of the photodiode layer sandwiched between the transparent electrode contacts, may be isolated from the laser structure by an intermediate, silicon nitride (SiN) insulating layer. In addition, the p-i-n layers may be formed of hydrogenated amorphous silicon (a-Si:H).

According to a process comprising one embodiment of the present invention, a surface emitting laser structure is formed by processes otherwise well known in the art. The detector structure is deposited directly thereupon at low temperatures, and in a manner that otherwise does not adversely affect the performance of the laser structure. Alternatively, the detector structure may be formed on a glass, quartz or similarly transparent substrate, then subsequently bonded to the surface emitting laser structure. The bonding process and materials selected are benign to the structure and operation of both the laser and detector structures.

The shortcomings of the prior techniques are addressed since no additional photolithography of the GaAs surface emitting laser structure is required. Any deposition, exposure, etching, etc., required to fabricate the detector structure takes place subsequent to and separate from the processing of the laser structure. And, as mentioned, the processes involved in fabricating the detector structure may be made benign to the underlying surface emitting laser structure.

The distances which the electrons or holes must travel is reduced from prior techniques, since the thickness of the n-i-p layer is much smaller than one-half of the diameter of the annular detector electrode taught by prior techniques.

Since the detector electrodes of the structure taught herein are formed of transparent ITO, and the a-Si:H p-i-n layers are much more transparent than the GaAs there is much more freedom provided to design optimal layer thicknesses for characteristics such as reflection. Finally, the characteristics of a-Si:H sensor arrays have been studied for some time, and the benefits of these studies may be employed in the integrated surface emitting laser and detector structure.

Particular embodiments in accordance with this invention will now be described with reference to the accompnaying drawings, in which:
Fig. 1 is a perspective view of a vertical cavity surface emitting laser structure with integrated detector structure according to the prior art,
Fig. 2 is a cross-sectional view of an vertical cavity surface emitting laser structure and integrated detector structure according to a first embodiment of the present invention,
Fig. 3 is a cross-sectional view of a vertical cavity surface emitting laser structure and integrated detector structure, in which the two structures are bonded together, according to a second embodiment of the present invention,
Fig. 4 is a plot of wavelength versus absorption for several amorphous alloys illustrating the ability to select alloys for a desired absorption,
Fig. 5 is a cross-sectional view of an improved vertical cavity surface emitting laser structure and integrated detector structure, in which the two structures are bonded together with electrically conductive bump bonds, according to a third embodiment of the present invention, and,
Fig. 6 is a cross-sectional view of another embodiment of the present invention employing a photoconductive layer as a component of an integrated detector.

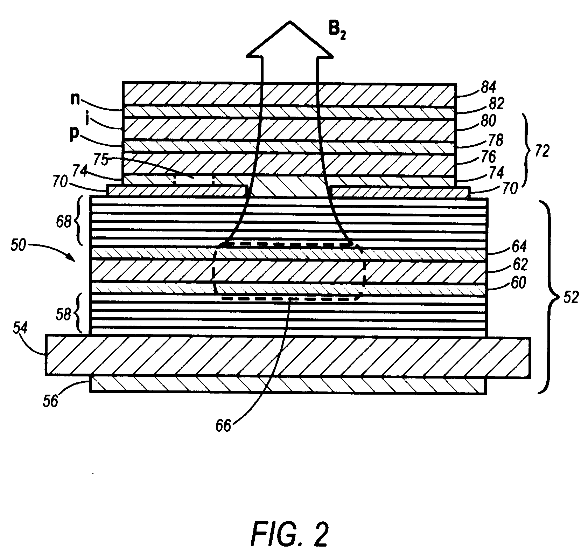

An integrated surface emitting laser and detector structure 50 according to one embodiment of the present invention shall now be described with reference to Fig. 2. A fundamental component of the present invention is the vertical cavity surface emitting laser (VCSEL) structure 52. As illustrated in Fig. 2, VCSEL structure 52 includes a substrate 54, for example n-type gallium arsenide (GaAs). The doping of the GaAs substrate 54 may typically be in the range of 5 x 10¹⁸ cm⁻³. Formed on or below a first side of substrate 54 is first electrode layer 56. Typically, this first electrode layer 56 is an n-type material, such as an alloy of germanium and gold (GeAu).

Formed on or over a second side of substrate 54 is mirror structure 58. Mirror structure 58 (as well as other mirror structures described herein) may be a super lattice of multiple thin layers, or other type structure forming, for example, a distributed Bragg reflector ("DBR"). A buffer layer of about 200 to 800 nanometers (nm), which is not shown in Fig. 2, may be first formed on substrate 54 so that it lies between substrate 54 and mirror structure 58. This lower mirror structure 58 provides part of the necessary internal reflection required to form the VCSEL.

Lower mirror structure 58 typically comprises multiple high and low aluminum content aluminum gallium arsenide (AlGaAs) or aluminum arsenide (AlAs) alloy layer pairs. Each of these layers have an aluminum content, in the range of 0% to 15% for the low aluminum layers, and in the range of 85% to 100% for the high aluminum layers, controlled so that they achieve a desired refractive index in each layer. A typical target refractive index for the high aluminum layer is around 3.1 to 3.2, and the target refractive index for the low aluminum layer is around 3.5 to 3.6. The aluminum content of these layers must also be controlled to render them non-absorptive at the lasing wavelength. The uppermost layer of the lower mirror structure is typically a high aluminum content layer.

The target total thickness of each of the layer pairs is one half of the optical wavelength at the desired laser operation wavelength. The target thickness of the uppermost layer of the lower mirror structure 58 is one quarter of the optical wavelength at the desired laser operation wavelength. A typical laser operation wavelength is 820 nm.

Since the laser output is outcoupled through only one surface (the upper surface) of the VCSEL, high internal reflection will maximize the laser output. High internal reflection also generally reduces the threshold current of the laser. Thus, the reflectivity of the lower mirror structure 58 should be as close to 100% as possible. It is well-known that the reflectivity of the lower mirror structure 58 is, in part, a function of the difference in the refractive indices between the high and low aluminum content layers. The reflectivity is also a function of the number of layer pairs in the structure. The greater the difference in the refractive indices, the fewer number of layer pairs are required to reach a given reflectivity. Typically, 20 to 40 pairs of high and low aluminum content layers are used to form the lower mirror structure 58. Lower mirror structure 58 will generally be doped so as to be of n-type material. Silicon is a common material with which lower mirror structure 58 may be doped to render it n-type.

Formed on or over mirror structure 58 is first spacer layer 60. Spacer layer 60 is typically formed of AlGaAs with an aluminum content of about 40%, and a thickness of about 100 nm. First spacer layer 60 may be doped with silicon, selenium, tellurium, etc. to a concentration of about 1 to 3 x 10¹⁸ cm⁻³. Generally, the uppermost 20 nm of first spacer layer 60 remain undoped.

On or over first spacer layer 60 is active layer 62. Active layer 62 may be a single quantum well structure formed of GaAs or p- or n-doped GaAs or Al_{z}Ga_{1-z}As, where z is very small. Alternatively, active layer 62 may be a relatively thin conventional double heterostructure (DH) structure, a multiple quantum well structure, such as alternating layers of materials such as GaAs and Al_{z}Ga_{1-z}As, or one of many other known structures for active layers of semiconductor lasers.

On or over active layer 62 is second spacer layer 64. As with first spacer layer 60, second spacer layer 64 is typically formed of AlGaAs with an aluminum content of about 40%, and a thickness of about 100 nm. Second spacer layer 64 may be doped with magnesium, carbon, zinc, etc. to a concentration of about 1 to 3 x 10¹⁸ cm⁻³. Generally, the lowermost 20 nm of first spacer layer 64 remain undoped. First spacer layer 60, active layer 62, and second spacer layer 64 together form the optical cavity 66 in which the desired optical gain is achieved. The combined optical thickness of the layers comprising this optical cavity is optimally equal to an integral multiple of half of the optical wavelength in the cavity.

On or above second spacer layer 64 is upper mirror structure 68. Upper mirror structure 68 forms another DBR mirror, and is structurally similar to lower mirror structure 58, except that it is doped to have opposite polarity. That is, if lower mirror structure 58 is doped n-type, upper mirror structure 68 is then doped p-type. In addition, upper mirror structure 68 is formed to have a slightly reduced reflectivity as compared to lower mirror structure 58 for the reason that the optical emission is to be outcoupled therethrough. Typically, upper mirror structure 68 will have a reflectivity on the order of 98% to 99%.

On or above upper mirror structure layer 68 is second electrode 70. Second electrode 70 is typically formed of a chrome and gold bilayer, a titanium, platinum, and gold trilayer, or other similar metal system. As previously discussed, since the material from which second electrode 70 is formed is typically opaque, second electrode 70 must provide a region through which the laser beam may exit the VCSEL structure. Second electrode 70 must have a large surface area contact with its contiguous underlying layer to provide minimal electrical resistance, yet be small enough to permit formation of high density arrays of VCSELs. Thus, second electrode 70 often has an annular, hollow elliptical or similar planform shape. Finally, since second electrode 70 is in contact with what has previously (and arbitrarily) been referred to as the p-type mirror, it is also referred to as the p-type electrode. Thus is presented an exemplary VCSEL according to one embodiment of the present invention.

VCSELs are ideally suited to integration into large numbers of nearly identical devices (arrays). Lithographic techniques and ion beam processing have yielded VCSELs with diameters below 1 micrometer. The accompanying reduction in the active volume of the VCSEL decreases driving threshold currents, and permits formation of large, complex structures of coherently coupled arrays. However, formation of such devices is process dependent. One process for forming such VCSELs is ion implantation. Such a process is well known in the art (see, e.g., Morgan et al., IEEE Photonics Technology Letters, vol. 7, no. 5, 1995, pp. 441 et seq., and the references cited therein).

Formed atop (from the perspective of Fig. 2) VCSEL 52 is detector structure 72. It is important to appreciate that VCSEL 52 and the detector structure 72 are formed of different materials. The material of the active layer 62 of VCSEL 52 is defined as the predominant material from which VCSEL 52 is formed. Detector structure 72 will generally include one or more photoconductive layers. The material forming these photoconductive layers is defined as the predominant material from which detector structure 72 is formed. In the case of structures having mixed material systems, the material comprising the greatest volume of the component, excluding the electrodes of such component, is defined herein as the predominant material from which such component is formed. The difference in the materials from which VCSEL 52 and detector structure 72 are predominantly formed may be a difference in alloys, differences in compositions, difference in crystal structures (e.g., single crystal, polycrystalline, and amorphous), etc.

Detector structure 72 is essentially a photodetector and electrodes. For example, detector structure may be a p-i-n photodiode with electrodes above and below (although other types of detector structures such as single photoconductive layer devices may also be employed within the scope of the present invention). Separating and disposed between VCSEL 52 and detector structure 72 is intermediate, or insulating layer 74. Insulating layer 74 may be formed of silicon nitride (SiN), and serves to electrically insulate second electrode 70 and the electrical components forming portions of detector structure 72.

Formed on or above insulating layer 74 is first detector electrode 76, which is formed of a material both electrically conductive and transparent to light at the wavelength of the emission of VCSEL 52. An example of an appropriate material for first detector electrode 76 is indium tin oxide (ITO). First detector electrode 76 may be on the order of 1000 Å thick. Optionally, detector electrode 76 and second electrode 70 may be in electrical communication with one another, for example by way of a via and conductive material 75 in insulating layer 74.

Formed on or above first detector electrode 76 is doped hydrogenated amorphous silicon (a-Si:H) layer 78. Layer 78 is for the most part transparent to light at the wavelength of VCSEL 52. Layer 78 in one embodiment is doped p+.

Formed on or over layer 78 is intrinsic a-Si:H layer 80. It is in this layer that the incident light generates electron-hole pairs by means well know in the art to enable detection and quantification of the power of the light passing therethrough.

Formed on or above intrinsic a-Si:H layer 80 is doped hydrogenated amorphous silicon (a-Si:H) layer 82. Layer 82 is for the most part transparent to light at the wavelength of VCSEL 52. Layer 82 in the present embodiment is doped n+.

Finally, formed on or above doped a-Si:H layer 82 is upper detector electrode 84. The structure and composition of upper detector electrode 84 is the same as that of lower detector electrode 76. For example, upper detector electrode 84 may be formed of ITO, and may be on the order of 1000 Å thick.

It is desirable that intrinsic a-Si:H layer 80 be in the range of 0.1 to 2.0 microns. A relatively thick layer 80 will result in proportionally higher ionization cause by the incident light. However, as the thickness of layer 80 increases, so must the applied bias increase in order to ensure that the electron-hole pairs generated throughout the layer are efficiently collected and positioned at the appropriate electrodes.

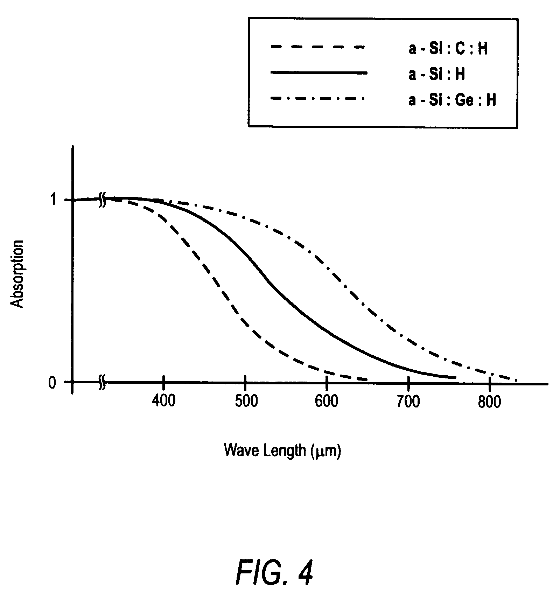

Thickness and composition of an a-Si:H film may be chosen to provide the desired absorption of, for example, about 5%. The a-Si:H can be alloyed with germanium of carbon, as well known in the art, to obtain desired absorption. As illustrated in Fig. 4, long wavelength absorption (for detectors to be employed with long wavelength lasers) may be obtained from a-Si:Ge:H, while short wavelength absorption (for detectors to be employed with short wavelength lasers) may be obtained from a-Si:C:H.

Also as well known in the art, a-Si:H and its alloys can be deposited by plasma enhanced chemical vapor deposition (PECVD). Source gases include SiH₄, GeH₄, CH₄, etc.

The integrally formed structures may then be connected as follows. A controlled bias applied across first electrode 56 and second electrode 70 (the driving current) will result in generation of laser beam B₂ from structure 52. The optical power of beam B₂ is, in part, a function of the level of the driving current. The power of beam B₂ will be detected by detector structure 72, for example by measuring the bias between detector electrodes 76 and 84 resulting from the beam's generation of electron-hole pairs in intrinsic layer 80. One example of the use of this optical power information is driving current level control by appropriate hardware and/or software (not shown). For example, should detector structure 72 indicate that the beam power is below a desired level, the driving current may be caused to increase, thereby increasing optical power, and similarly, should detector structure 72 indicate that the beam power is above a desired level, a decrease in the driving current may be effected to reduce the optical power.

Information regarding the optical power of beam B₂ may be employed in other ways, for example, to measure the aging of a laser to anticipate its need for replacement, to distinguish between various possible output states of the laser structure 52 such as in communications systems, etc. Importantly, the novel structure taught hereby is not limited by its use, and the benefits of such structure extend across many fields of application.

Importantly, in detecting the power of beam B₂, detector structure 72 only minimally attenuates the power of beam B₂, and since it is transparent, its physical dimensions are not governed by either the laser structure's electrode size and shape nor by the laser beam's diameter.

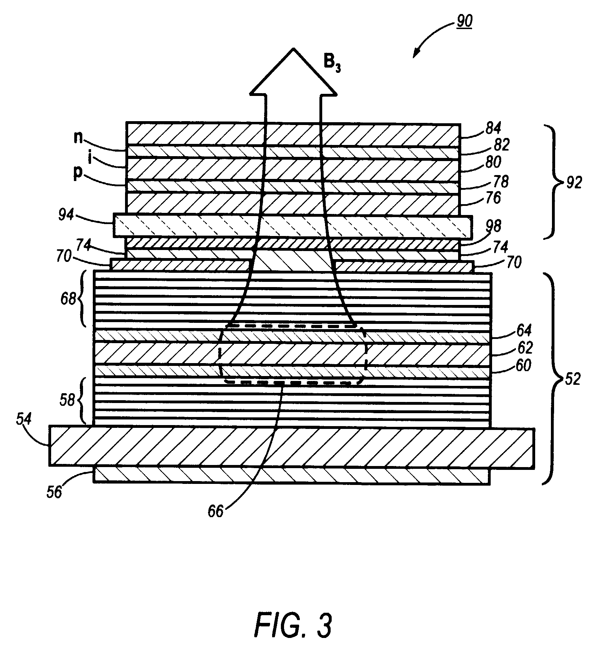

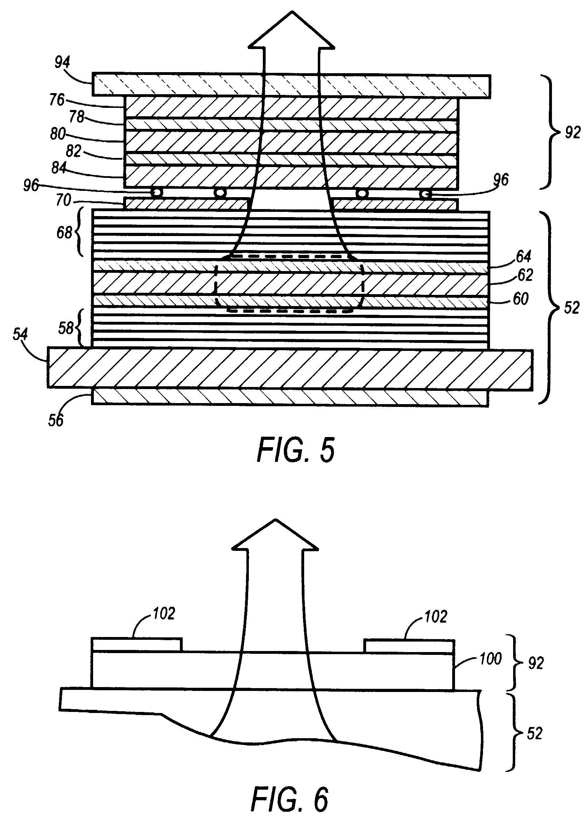

Referring now to Fig. 3, there is shown therein another embodiment of an integrated laser and detector structure 90 according to the present invention. According to this embodiment, a VCSEL structure 52 is first formed as previously described. An insulating layer 74 is also deposited over the second laser electrode 70 of VCSEL 52, as previously described. A detector structure 92 is next formed, employing an optically transparent substrate 94 which is independent of the VCSEL structure. The VCSEL structure 52 and detector structure 92 are then merged into a single structure, to provide each of the advantages previously discussed. Detector structure 92 may be a photoconductive layer (e.g., photoconductive layer 100 with electrodes 102 shown in Fig. 6), a p-i-n structure (as further described below), or other suitable detecting structure.

More specifically, substrate 94 is optically transparent at the wavelength of operation of VCSEL 52. Examples of appropriate materials for substrate 94 include optical glass and quartz. Forming sensor structures on these substrate materials are well known in areas of liquid crystal displays, radiographic imaging using arrays of thin-film transistor image sensors, and the like. Thus, formation of the detector structure 92 proceeds independently of the formation of VCSEL 52, and by methods otherwise well known, such as those described above.

Once detector structure 92 is completed, it may then be physically bonded to VCSEL 52, post-formation (i.e., following the complete formation, and testing if appropriate, of each structure). For example, the two separate structures may be epoxied together as shown in Fig. 3, with substrate 94 bonded directly to insulating layer 74. In such case, the adhesive would be transparent at the wavelength of the laser. Of course, detector structure 92 may also be similarly secured to VCSEL 52 such that electrode layer 84 is bonded to insulating layer 74, provided that electrical contact may be made to layer 84. Indeed, since the laser beam may diverge in passing through the transparent substrate, in order to maximize the packing density of VCSELs in an array of such devices, this inverted attachment may be beneficial.

As an alternative, bump bonding may be employed to join the two otherwise independent structures into a single, integrated structure. As shown in Fig. 5, detector structure 92 would typically be inverted in this embodiment so that detector electrode 84 may be in electrical contact with VCSEL electrode 70 via conductive bonding bumps 96 formed, for example, of indium/gold, or other well known suitable materials. Any gap between VCSEL structure 52 and detector structure 92 will typically be filled with air. Devices for performing such bump bonding are well known in the art, for example SEC Model 410 Flip Chip Die Bonder from Semiconductor Equipment Corporation, Moorpark, CA. USA.

Advantageously, since the detector structure 92 is essentially transparent, and is not limited by the requirement of annular electrodes through which the laser beam must pass, the alignment tolerance between the VCSEL 52 and the detector structure 92 provided by the present invention is significantly more forgiving than that provided by architectures taught by the prior art. This greatly simplifies the integration of the two structures.

One advantage of this embodiment of the present invention is the ability to independently fabricate each of the VCSEL structure 52 and the detector structure 92, allowing use of optimized fabrication techniques for each. In addition, the independent partial or complete fabrication of each structure allows for isolation of the manufacturing steps, which eliminates any risk of damaging one structure during or as a result of the fabrication of the other structure. Independent testing of each of the VCSEL and detector structures also allows for improved yield by early identification of malfunctioning components.

One variation of the aforementioned embodiment is the partial completion of the detector structure, the bonding of the detector structure to the completed VCSEL, and the subsequent completion of the formation of the detector structure. This may be advantageous where, for example, it is desirable to complete the formation of the integrated structure in the form of a single substrate array, or where it is desirable for one party to complete fabrication of the device up to one point, then deliver a partially completed structure over to a second party to complete the fabrication.

## Claims

1. An integrated semiconductor laser and detector structure, comprising:
a vertical cavity, surface emitting laser (52), which emits light at a wavelength, and which is formed predominantly of a first material; and,
a detector (72) which is relatively transparent to light at the wavelength emitted by said laser, and which is formed predominantly of a second material different from said first material;
said laser (52) and said detector (72) being aligned such that at least a portion of the light emitted by the laser (52) is directed through the detector (72).

2. An integrated semiconductor device according to claim 1, in which said laser (52) and said detector (72) are separated from one another by no more than one intermediate, relatively transparent layer (74, 94) disposed between them.

3. An integrated semiconductor device according to claim 1 or 2, wherein the photodetector (72) is a p-i-n photodetector consisting of layers of material selected from the group comprising hydrogenated amorphous silicon and alloys of hydrogenated amorphous silicon.

4. A method of forming an integrated semiconductor laser (52) and detector (72) structure, comprising the steps of:
forming a vertical cavity, surface emitting laser (52) with uppermost insulating layer (74), which emits light at a wavelength, and which is formed primarily of a first material; and
providing over said vertical cavity, surface emitting laser (52) a detector (72) comprising a photodetector (78, 80, 82) and electrodes (76, 84), said photodetector (78, 80, 82) and said electrodes (76, 84) being relatively transparent to light at the wavelength emitted by said laser (52), and said detector (72) formed primarily of a second material different from said first material;
said laser (52) and said detector (72) being aligned such that at least a portion of the light emitted by the laser (52) is directed through the photodetector (78, 80, 82) and electrodes (76, 84).

5. A method according to claim 4, wherein said detector (72) is formed in situ directly on said uppermost insulating layer (74) of said laser (52).

6. A method according to claim 4, wherein said detector includes a transparent substrate (94), and further wherein said detector is initially formed in part or completely on said transparent substrate (94), then bonded to said laser (52).
